(19) Europäisches Patentamt
European Patent Office
Office européen des brevets

(11) EP 3 853 026 B1

(12) **EUROPEAN PATENT SPECIFICATION**

(45) Date of publication and mention of the grant of the patent:
**31.05.2023 Bulletin 2023/22**

(21) Application number: **19774004.6**

(22) Date of filing: **09.09.2019**

(51) International Patent Classification (IPC):
***B41C 1/10*** *(2006.01)* ***B41M 5/323*** *(2006.01)*
***B41M 5/327*** *(2006.01)* ***B41M 5/333*** *(2006.01)*
***B41M 5/337*** *(2006.01)*

(52) Cooperative Patent Classification (CPC):
**B41C 1/1008;** B41C 1/1016; B41C 2201/02; B41C 2201/14; B41C 2210/04; B41C 2210/08; B41C 2210/22; B41M 5/323; B41M 5/327; B41M 5/3275; B41M 5/3335; B41M 5/3375

(86) International application number:
**PCT/US2019/050149**

(87) International publication number:
**WO 2020/060784 (26.03.2020 Gazette 2020/13)**

(54) **LITHOGRAPHIC PRINTING PLATE PRECURSOR AND COLOR-FORMING COMPOSITION**

FLACHDRUCKPLATTENVORLÄUFER UND FARBBILDENDE ZUSAMMENSETZUNG

PRÉCURSEUR DE PLAQUE D'IMPRESSION LITHOGRAPHIQUE ET COMPOSITION DE FORMATION DE COULEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.09.2018 US 201816137676**

(43) Date of publication of application:
**28.07.2021 Bulletin 2021/30**

(73) Proprietor: **Eastman Kodak Company**
**Rochester, NY 14650-2201 (US)**

(72) Inventors:
- **IGARASHI, Akira**
  **Rochester, NY 14650-2201 (US)**
- **TORIHATA, Yuuki**
  **Rochester, NY 14650-2201 (US)**
- **ISHII, Satoshi**
  **Rochester, NY 14650-2201 (US)**

(74) Representative: **Vossius & Partner Patentanwälte Rechtsanwälte mbB**
**Siebertstrasse 3**
**81675 München (DE)**

(56) References cited:
**EP-A1- 3 184 590**
**US-A- 5 008 238**
**US-A1- 2009 047 599**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 853 026 B1

## Description

### FIELD OF THE INVENTION

This invention relates to a negative-working lithographic printing plate precursor that can be imaged using radiation such as infrared radiation to provide imaged lithographic printing plate precursors with improved printout images. Such precursors include a color-forming composition to provide the printout image. This invention also relates to a method for imaging and on-press processing of such negative-working lithographic printing plate precursors.

### BACKGROUND OF THE INVENTION

In lithographic printing, lithographic ink receptive regions, known as image areas, are generated on a hydrophilic surface of a planar substrate. When the printing plate surface is moistened with water and a lithographic printing ink is applied, hydrophilic regions retain the water and repel the lithographic printing ink, and the lithographic ink receptive image regions accept the lithographic printing ink and repel the water. The lithographic printing ink is transferred to the surface of a material upon which the image is to be reproduced, perhaps with the use of a blanket roller.

Negative-working lithographic printing plate precursors useful to prepare lithographic printing plates typically comprise a negative-working radiation-sensitive imageable layer disposed over the hydrophilic surface of a substrate. Such an imageable layer includes radiation-sensitive components that can be dispersed in a suitable polymeric binder material. After the precursor is imagewise exposed to suitable radiation to form exposed regions and non-exposed regions, the non-exposed regions of the imageable layer are removed by a suitable developer, revealing the underlying hydrophilic surface of the substrate. The exposed regions of the imageable layer that are not removed are lithographic ink-receptive, and the hydrophilic substrate surface revealed by the developing process accept water and aqueous solutions such as a fountain solution and repel lithographic printing ink.

In recent years, there has been a desire in the lithographic printing industry for simplification in making lithographic printing plates by carrying out development on-press ("DOP") using a lithographic printing ink or fountain solution, or both, to remove non-exposed regions of the imageable layer. Thus, use of on-press developable lithographic printing plate precursors is being adopted more and more in the printing industry due to many benefits over traditionally processed lithographic printing plate precursors, including less environmental impact and savings on processing chemicals, processor floor space, operation and maintenance costs. After laser imaging, on-press developable precursors are taken directly to printing presses without the step of removing the radiation-sensitive imageable layer in the non-printing regions of the imaged precursors.

It is highly desirable that the laser imaged printing plate precursors have different colors in the exposed and non-exposed regions. The color difference between the exposed and unexposed regions is typically called "printout" (or "print-out"). A strong printout will make it easier for operators to visually identify the imaged printing plate precursors and to attach the imaged printing plate precursors to proper press units.

Many approaches have been taken to strengthen the printout of on-press developable printing plate precursors. For example, U.S. Patent Application Publication 2009/0047599 (Horne et al.) describes the use of spirolactone or spirolactam colorant precursors with a ring-opening acid to provide printout images. However, the printout images provided with this chemistry can fade over time so that they are no longer readable by press operators if the imaged precursors are not used immediately.

Thus, there is a need to provide printout images in imaged lithographic printing plate precursors that exhibit reduced printout fading.

### SUMMARY OF THE INVENTION

The present invention provides a color-forming composition comprising:

(a) an acid generator;
(b) a tetraaryl borate;
(c) an acid-sensitive dye precursor; and
(d) a compound having the following Structure (I):

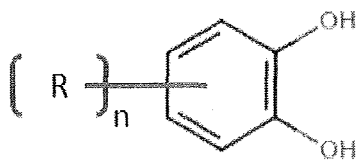

(I)

wherein n is 1, 2, 3, or 4; R independently represents a monovalent substituent or the atoms necessary to form a fused ring if n is at least 2, and at least one R substituent is an electron-withdrawing group.

In addition, the present invention provides a lithographic printing plate precursor comprising:

a substrate comprising a hydrophilic surface;
a radiation-sensitive imageable layer that is disposed on the hydrophilic surface of the substrate, the radiation-sensitive imageable layer comprising:

one or more free radically polymerizable components,
one or more radiation absorbers,
a color-forming composition consisting of:

(a) an acid generator;
(b) a tetraaryl borate;
(c) an acid-sensitive dye precursor; and
(d) a compound having the following Structure (I):

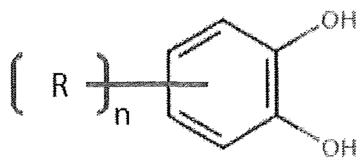

(I)

wherein n is 1, 2, 3, or 4; and R independently represents a monovalent substituent or the atoms necessary to form a fused ring if n is at least 2, and at least one R substituent is an electron-withdrawing group, and optionally, a polymeric binder different from the one or more free radically polymerizable components, and

the lithographic printing plate precursor optionally comprising a protective layer disposed over the radiation-sensitive imageable layer.

In addition, the present invention provides a method for forming a lithographic printing plate, comprising:

A) imagewise exposing a lithographic printing plate precursor according to any embodiment described herein with radiation, to provide exposed regions and non-exposed regions in the radiation-sensitive imageable layer; and
B) removing the non-exposed regions of the radiation-sensitive imageable layer.

For example, the method can be carried out by
B) removing the non-exposed regions of the radiation-sensitive imageable layer on-press using a lithographic printing ink, a fountain solution, or a combination of a lithographic printing ink and a fountain solution.

The lithographic printing plate precursors of the present invention can display improved printout images upon imaging. Such printout images do not fade as quickly as printout images generated using known chemistry. These advantages are provided by incorporating a color-forming composition into the radiation-sensitive imageable layer of

such precursors. This color-forming composition includes several essential components (a) through (d) described below. In some embodiments, the molar ratio of component (d) to component (b), or the d/b ratio, is at least 0.25, or at least 0.35.

Further advantages and benefits of the present invention will be evident from the teaching and working Examples provided below.

## BRIEF DESCRIPTION OF THE DRAWINGS

FIG. 1 is a graphical representative of ΔOD data provided in Invention Example 1 and Comparative Examples 1-3 described below.

FIG. 2 is a graphical representative of ΔOD data provided in Invention Example 1 and Comparative Example 4 described below.

Fig. 3 is a graphical representative of ΔOD data provided in Invention Example 5 described below.

## DETAILED DESCRIPTION OF THE INVENTION

The following discussion is directed to various embodiments of the present invention and while some embodiments can be desirable for specific uses, the disclosed embodiments should not be interpreted or otherwise considered to limit the scope of the present invention, as claimed below. In addition, one skilled in the art will understand that the following disclosure has broader application than is explicitly described in the discussion of any embodiment.

### Definitions

As used herein to define various components of the color-forming composition, radiation-sensitive imageable layer formulation, and other materials used in the practice of this invention, unless otherwise indicated, the singular forms "a," "an," and "the" are intended to include one or more of the components (that is, including plurality referents).

Each term that is not explicitly defined in the present application is to be understood to have a meaning that is commonly accepted by those skilled in the art. If the construction of a term would render it meaningless or essentially meaningless in its context, the term should be interpreted to have a standard dictionary meaning.

The use of numerical values in the various ranges specified herein, unless otherwise expressly indicated otherwise, are to be considered as approximations as though the minimum and maximum values within the stated ranges were both preceded by the word "about." In this manner, slight variations above and below the stated ranges may be useful to achieve substantially the same results as the values within the ranges. In addition, the disclosure of these ranges is intended as a continuous range including every value between the minimum and maximum values as well as the end points of the ranges.

Unless the context indicates otherwise, when used herein, the terms "negative-working, radiation-sensitive lithographic printing plate precursor," "precursor," and "lithographic printing plate precursor" are meant to be equivalent references to embodiments of the present invention.

As used herein, the term "infrared radiation absorber" refers to a compound or material that absorbs electromagnetic radiation in the infrared region and typically refers to compounds or materials that have an absorption maximum in the infrared region.

As used herein, the term "infrared region" refers to radiation having a wavelength of at least 750 nm and higher. In most instances, the term "infrared" is used to refer to the "near-infrared" region of the electromagnetic spectrum that is defined herein to be at least 750 nm and up to and including 1400 nm.

For the purposes of this invention, a printout image is generally defined as a difference in the absolute value of optical density in exposed regions and the optical density in non-exposed regions in an imaged lithographic printing plate precursor. This difference in the absolute value of optical density (ΔOD) can be measured using a general reflection densitometer or spectrophotometer, for example, a commercially available X-rite 528 densitometer (neutral filter), as described below in the Examples. For purposes of the present invention, a desired ΔOD is at least 0.08, or even at least 0.09, when using an exposure energy of at least 120 $mJ/cm^2$ for infrared radiation exposure.

For clarification of definitions for any terms relating to polymers, reference should be made to "Glossary of Basic Terms in Polymer Science" as published by the International Union of Pure and Applied Chemistry ("IUPAC"), Pure Appl. Chem. 68, 2287-2311 (1996). However, any definitions explicitly set forth herein should be regarded as controlling.

As used herein, the term "polymer" is used to describe compounds with relatively large molecular weights formed by linking together many small reacted monomers. As the polymer chain grows, it folds back on itself in a random fashion to form coiled structures. With the choice of solvents, a polymer can become insoluble as the chain length grows

and become polymeric particles dispersed in the solvent medium. These particle dispersions can be very stable and useful in radiation-sensitive imageable layers described for use in the present invention. In this invention, unless indicated otherwise, the term "polymer" refers to a non-crosslinked material. Thus, crosslinked polymeric particles differ from the non-crosslinked polymeric particles in that the latter can be dissolved in certain organic solvents of good solvating property whereas the crosslinked polymeric particles may swell but do not dissolve in the organic solvent because the polymer chains are connected by strong covalent bonds.

The term "copolymer" refers to polymers composed of two or more different repeating or recurring units that are arranged along the polymer backbone.

The term "backbone" refers to the chain of atoms in a polymer to which a plurality of pendant groups can be attached. An example of such a backbone is an "all carbon" backbone obtained from the polymerization of one or more ethylenically unsaturated polymerizable monomers.

Recurring units in polymeric binders described herein are generally derived from the corresponding ethylenically unsaturated polymerizable monomers used in a polymerization process, which ethylenically unsaturated polymerizable monomers can be obtained from various commercial sources or prepared using known chemical synthetic methods.

As used herein, the term "ethylenically unsaturated polymerizable monomer" refers to a compound comprising one or more ethylenically unsaturated (-C=C-) bonds that are polymerizable using free radical or acid-catalyzed polymerization reactions and conditions. It is not meant to refer to chemical compounds that have only unsaturated -C=C- bonds that are not polymerizable under these conditions.

Unless otherwise indicated, the term "weight %" refers to the amount of a component or material based on the total solids of a composition, formulation, or layer. Unless otherwise indicated, the percentages can be the same for either a dry layer or the total solids of the formulation or composition.

As used herein, the term "layer" or "coating" can consist of one disposed or applied layer or a combination of several sequentially disposed or applied layers. If a layer is considered infrared radiation-sensitive and negative-working, it is both sensitive to radiation (as described above for "radiation-absorber") and negative-working in the formation of lithographic printing plates.

**Uses**

The color-forming compositions according to the present invention is useful to provide printout images in imaged lithographic printing plate precursors, which in turn are useful for forming lithographic printing plates for lithographic printing on-press during press operations using a lithographic printing ink, fountain solution, or both. These precursors are prepared with the structure and components described as follows.

**Color-Forming Compositions**

The color-forming compositions according to the present invention comprise at least four components: (a) through (d) that are defined as follows.

Component (a) is an acid generator that is a compound that will provide a proton upon exposure to infrared radiation in the presence of an infrared radiation absorber, which proton is used to cause formation of an observable color from the colorless (c) acid-sensitive dye precursor described below. Mixtures of two or more of such (a) compounds can be used if desired.

Representative (a) acid generators include but are not limited to, organohalogen compounds such as trihaloallyl compounds, halomethyl triazines, and bis(trihalomethyl) triazines many of which are known in the art; as well as onium salts such as iodonium salts, sulfonium salts, diazonium salts, phosphonium salts, and ammonium salts, many of which are known in the art. For example, representative compounds other than onium salts are described for example in [0087] of U.S. Patent Application Publication 2005/0170282 (Inno et al.).

Useful onium salts are described for example from [0103] to [0109] of the cited US ’282.

For example, useful onium salts comprise a cation having at least one onium ion atom in the molecule, and an anion. Examples of the onium salts include triphenylsulfonium, diphenyliodonium, diphenyldiazonium, and derivatives thereof that are obtained by introducing one or more substituents into the benzene ring of these compounds. Suitable substituents include but are not limited to, alkyl, alkoxy, alkoxycarbonyl, acyl, acyloxy, chloro, bromo, fluoro and nitro groups.

Examples of anions in the onium salts include but are not limited to, halogen anions, $ClO_4^-$, $PF_6^-$, $BF_4^-$, $SbF_6^-$, $CH_3SO_3^-$, $CF_3SO_3^-$, $C_6H_5SO_3^-$, $CH_3C_6H_4SO_3^-$, $HOC_6H_4SO_3^-$, $ClC_6H_4SO_3^-$, and boron anion as described for example in U.S. Patent 7,524,614 (Tao et al.).

The onium salt can be a polyvalent onium salt having at least two onium ion atoms in the molecule that are bonded through a covalent bond. Among polyvalent onium salts, those having at least two onium ion atoms in the molecule are useful and those having a sulfonium or iodonium cation in the molecule are useful. Representative polyvalent

onium salts are represented by the following formulas (6) and (7):

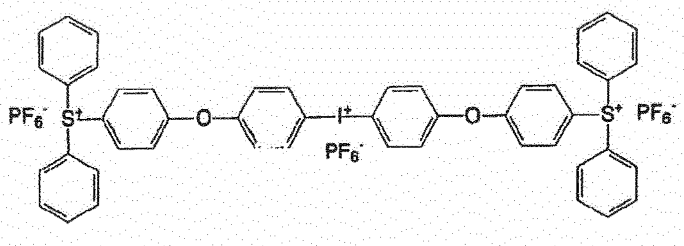

(6)

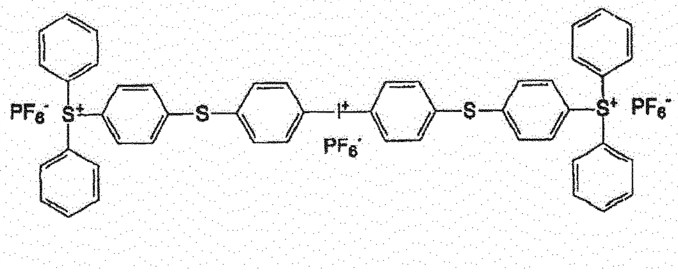

(7)

Furthermore, the onium salts described in paragraphs [0033] to [0038] of the specification of Japanese Patent Publication 2002-082429 [or U.S. Patent Application Publication 2002-0051934 (Ippei et al.)], or the iodonium borate complexes described in U.S. Patent 7,524,614 (noted above), can also be used in the present invention.

In some embodiments, the onium salts can include an "acid-generating cation and a tetraaryl borate anion that is present as the (b) tetraaryl borate component according to the present invention. In other words, component (a) and component (b) can be present in the same, or as one molecule.

In some embodiments, a combination of (a) acid-generators can be used such as a combination of Compound A represented by Structure (II) shown below, and one or more compounds collectively known as compound B represented below by either Structure (III) or (IV):

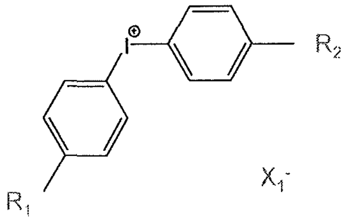

(II)

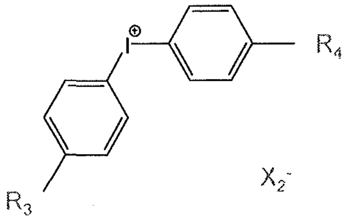

(III)

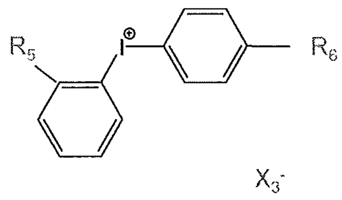

(IV)

In these Structures (II), (III), and (IV), $R_1$, $R_2$, $R_3$, $R_4$, $R_5$ and $R_6$ are independently substituted or unsubstituted alkyl groups or substituted or unsubstituted alkoxy groups, each of the alkyl or alkoxy groups has from 2 to 9 carbon atoms (or particularly from 3 to 6 carbon atoms). These substituted or unsubstituted alkyl and alkoxy groups can be in linear or branched form. In many useful embodiments, $R_1$, $R_2$, $R_3$, $R_4$, $R_5$ and $R_6$ are independently substituted or unsubstituted alkyl groups, such as independently chosen substituted or unsubstituted alkyl groups having 3 to 6 carbon atoms.

In addition, at least one of $R_3$ and $R_4$ can be different from $R_1$ or $R_2$; the difference between the total number of carbon atoms in $R_1$ and $R_2$ and the total number of carbon atoms in $R_3$ and $R_4$ is 0 to 4 (that is, 0, 1, 2, 3, or 4); the difference between the total number (sum) of carbon atoms in $R_1$ and $R_2$ and the total number (sum) of carbon atoms in $R_5$ and $R_6$ is 0 to 4 (that is, 0, 1, 2, 3, or 4); and $X_1$, $X_2$ and $X_3$ are the same or different anions. It is possible also that at least one of $X_1$, $X_2$ and $X_3$ is a (b) tetraaryl borate as described below.

Component (b) is a tetraaryl borate that is an organic borate compound, such as a salt, or tetraaryl borate anion composed of four of the same or different aryl groups, that in the color-forming composition and the radiation-sensitive imageable layer, can exhibit the function of and electron donor in a redox reaction with component (a). Representative aryl groups in such borate anions include but are not limited to, substituted or unsubstituted phenyl, substituted or unsubstituted naphthyl, and tolyl groups. Possible substituents on the aryl group(s) include fluoro, methyl, alkoxy, and acyloxy groups. Representative tetraaryl borates include but are not limited to, tetraphenyl borate, tetranaphthyl borate, triphenylnaphthyl borate, trinaphthylphenyl borate, and triphenylfluorophenyl borate. Mixtures of two or more of such (b) tetraaryl borates can be used if desired.

The noted tetraaryl borate anion can be present with any suitable cation that is known in the art, including for example, $Na^+$, $K^+$, and tetrabutylammonium ions.

As noted above, the (b) tetraaryl borate can be present in the same molecule as the (a) acid-generative cation such as an onium (or iodonium) cation.

Component (c) is an acid-sensitive dye precursor that is colorless or exhibits a different color until a proton is produced from the (a) acid generator described above. Representative compounds of this type include but are not limited to, triarylmethane-based compounds, diphenylmethane-based compounds, xanthene-based compounds, thiazine-based compounds, and spiropyran-based compounds, examples of which are described in [0066] to [0067] of US '282 noted above. Mixtures of two or more of such compounds can be used if desired.

Component (d) is a compound defined by Structure (1):

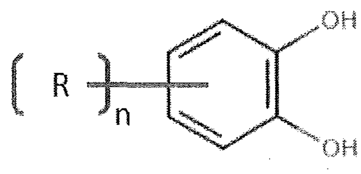

(I)

wherein n is 1, 2, 3, or 4; and particularly, n can be 1 or 2. R independently represents a monovalent substituent or the atoms necessary to form a fused ring if n is at least 2. At least one R substituent is an electron-withdrawing group, including but not limited to chloro, bromo, trifluoromethyl, nitro, cyano, alkoxycarbonyl, acyloxy and alkylcarbonyl groups.

The sum of *para* Hammett-Sigma values for the R substituents can be greater than 0, or even greater than 0.2.

Some useful component (d) compounds include but are not limited to, alkyl 3,4-dihydroxybenzoates wherein the alkyl group has 1 to 6 carbon atoms (such as methyl, ethyl, *n*-propyl, *iso*-propyl, *n*-butyl, *n*-pentyl, and *n*-hexyl), alkyl gallates wherein the alkyl group has 1 to 6 carbon atoms (such as methyl, ethyl, *n*-propyl, *iso*-propyl, *n*-butyl, *n*-pentyl, and *n*-hexyl), 4-chlorocatechol, 4-nitrocatechol, and 3,4-hydroxybenzonitrile. Mixtures of two or more of these (d) compounds can be used if desired.

In the color-forming compositions according to the present invention, components (a) through (d) can be present in the following amounts, all based on the total solids in the color-forming composition:

The one or more (a) acid generators can be present in an amount of at least 1% solids and up to and including 15% solids, or more likely at least 3% solids and up to and including 10% solids.

The one or more (b) tetraaryl borates (anions) can be present in an amount of at least 1% solids and up to and including 15% solids, or more likely at least 3% solids and up to and including 10% solids.

When component (a) and component (b) are present in the same molecule, the combined molecule can be present in an amount of at least 1% solids and up to and including 15% solids, or more likely at least 3% solids and up to and including 10% solids.

The one or more (c) acid-sensitive dye precursors can be present in an amount of at least 0.5% solids and up to and including 10% solids, or more likely at least 2% solids and up to and including 8% solids.

The one or more (d) compounds of Structure (1) can be present in an amount of at least 0.5% solids and up to and including 10% solids, or more likely at least 1% solids and up to and including 8% solids.

In addition, it is desirable that the molar ratio of component (d) to component (b) (referred to as d/b ratio below) is at least 0.25:1, and more likely, at least 0.5:1. When the d/b ratio is too small, the improvement in printout and printout stability is insignificant. On the other hand, when the d/b ratio is greater than 1:1, the incremental benefit from extra amount of component (d) becomes smaller. Thus, from economic point of view, the b/d ratio is generally less than or equal to 3:1, and more particularly, less than or equal to 2.2:1.

Representative (a) through (d) components can be obtained from various commercial sources or prepared using known chemical synthetic methods and starting materials.

The color-forming composition can be formulated by mixing the noted (a) through (d) components in a suitable solvent or mixture of solvents, including but not limited to, 2-butanol, 2-methoxypropanol, methanol, n-propanol, γ-butyrolactone, and such solvents or mixtures thereof that are described below for preparing a radiation-sensitive imageable layer formulation, in desired proportions to arrive at the desired % solids for each component. This formulated color-forming composition can then be incorporated into a radiation-sensitive imageable layer formulation as described below. Alternatively, each of the (a) through (d) components can be mixed individually with the other materials used to prepare a radiation-sensitive imageable layer as described below.

## Lithographic Printing Plate Precursors

The precursors according to the present invention can be formed by suitable application of a negative-working radiation-sensitive composition as described below to a suitable substrate (as described below) to form a radiation-sensitive imageable layer that is negative-working. In general, the radiation-sensitive composition (and resulting radiation-sensitive imageable layer) comprises one or more free radically polymerizable components, one or more radiation absorbers, a color-forming composition as described above, and optionally, a polymeric binder different from the one or more free radically polymerizable components. There is generally only one radiation-sensitive imageable layer in each precursor. It is generally the outermost layer in the precursor, but in some embodiments, there can be an outermost water-soluble hydrophilic protective layer (also known as a topcoat or oxygen barrier layer), as described below, disposed over the radiation-sensitive imageable layer.

### Substrate:

The substrate that is used to prepare the precursors according to this invention generally has a hydrophilic imaging-side planar surface, or at least a surface that is more hydrophilic than the applied radiation-sensitive imageable layer. The substrate comprises a support that can be composed of any material that is conventionally used to prepare lithographic printing plate precursors.

One useful substrate is composed of an aluminum-containing support that can be treated using techniques known in the art, including roughening of some type by physical (mechanical) graining, electrochemical graining, or chemical graining, which is followed by anodizing. Anodizing is typically done using phosphoric or sulfuric acid and conventional procedures to form a desired hydrophilic aluminum oxide (or anodic oxide) layer or coating on the aluminum-containing support, which aluminum oxide (anodic oxide) layer can comprise a single layer or a composite of multiple layers having multiple pores with varying depths and shapes of pore openings. Such processes thus provide an anodic oxide layer underneath a radiation-sensitive imageable layer that can be provided as described below. A discussion of such pores and a process for controlling their width is described for example in U.S. Patent Publication 2013/0052582 (Hayashi).

Sulfuric acid anodization of the aluminum support generally provides an aluminum (anodic) oxide weight (coverage) on the surface of at least 1 $g/m^2$ and up to and including 5 $g/m^2$ and more typically of at least 3 $g/m^2$ and up to

and including 4 $g/m^2$. Phosphoric acid anodization generally provides an aluminum (anodic) oxide weight on the surface of from at least 0.5 $g/m^2$ and up to and including 5 $g/m^2$ and more typically of at least 1 $g/m^2$ and up to and including 3 $g/m^2$.

An anodized aluminum support can be further treated to seal the anodic oxide pores or to hydrophilize its surface, or both, using known post-anodic treatment (PAT) processes, such as post-treatments in aqueous solutions of poly(vinyl phosphonic acid) (PVPA), vinyl phosphonic acid copolymers, poly[(meth)acrylic acid] or its alkali metal salts, or acrylic acid copolymers or their alkali metal salts, mixtures of phosphate and fluoride salts, or sodium silicate. The PAT process materials can also comprise unsaturated double bonds selectively enhance adhesion between the treated surface and the radiation-sensitive imageable layer in the radiation exposed regions. Such unsaturated double bonds can be provided in low molecular weight materials or they can be present within side chains of polymers. Useful post-treatment processes include dipping the substrate with rinsing, dipping the substrate without rinsing, and various coating techniques such as extrusion coating.

For example, as noted in US ’582 cited above, an anodized substrate can be treated with an alkaline or acidic pore-widening solution to provide an anodic oxide layer containing columnar pores so that the diameter of the columnar pores at their outermost surface is at least 90% of the average diameter of the columnar pores. In some embodiments, the treated substrate can comprise a hydrophilic layer disposed directly on a grained, anodized, and post-treated aluminum-containing support, and such hydrophilic layer can comprise a non-crosslinked hydrophilic polymer having carboxylic acid side chains.

In addition, an aluminum support can be subjected to multiple anodizing processes to modify the surface aluminum oxide formation, as described for example in U.S. Serial No. 447,651 (filed March 2, 2017 by Merka et al.).

The thickness of a substrate can be varied but should be sufficient to sustain the wear from printing and thin enough to wrap around a printing form. Useful embodiments include a treated aluminum foil having a thickness of at least 100 $\mu$m and up to and including 700 $\mu$m. The backside (non-imaging side) of the substrate can be coated with antistatic agents, a slipping layer, or a matte layer to improve handling and "feel" of the precursor.

The substrate can be formed as a continuous roll (or continuous web) of sheet material that is suitably coated with a radiation-sensitive imageable layer formulation and optionally a protective layer formulation, followed by slitting or cutting (or both) to size to provide individual lithographic printing plate precursors having a shape or form having four right-angled corners (thus, typically in a square or rectangular shape or form). Typically, the cut individual precursors have a planar or generally flat rectangular shape.

## Radiation-Sensitive Imageable Layer:

The radiation-sensitive composition (and radiation-sensitive imageable layer prepared therefrom) are designed to be "negative-working" and comprises one or more free radically polymerizable components, each of which contains one or more free radically polymerizable groups that can be polymerized using free radical initiation. In some embodiments, the radiation-sensitive imageable layer comprises two or more free radically polymerizable components having the same or different numbers of free radically polymerizable groups in each molecule.

In addition, the radiation-sensitive imageable layer can provide on-press developability to the lithographic printing plate precursor, for example using a fountain solution, a lithographic printing ink, or a combination of the two, for on-press development.

Useful free radically polymerizable components can contain one or more free radical polymerizable monomers or oligomers having one or more addition polymerizable ethylenically unsaturated groups (for example, two or more of such groups). Similarly, crosslinkable polymers having such free radically polymerizable groups can also be used. Oligomers or prepolymers, such as urethane acrylates and methacrylates, epoxide acrylates and methacrylates, polyester acrylates and methacrylates, polyether acrylates and methacrylates, and unsaturated polyester resins can be used. In some embodiments, the free radically polymerizable component comprises carboxyl groups.

It is possible for one or more free radically polymerizable components to have large enough molecular weight or to have sufficient polymerizable groups to provide a crosslinkable polymer matrix that functions as a "polymeric binder" for other components in the radiation-sensitive imageable layer. In such embodiments, a distinct non-polymerizable or non-crosslinkable polymer binder (described below) is not necessary but still may be present.

Free radically polymerizable components include urea urethane (meth)acrylates or urethane (meth)acrylates having multiple (two or more) polymerizable groups. Mixtures of such compounds can be used, each compound having two or more unsaturated polymerizable groups, and some of the compounds having three, four, or more unsaturated polymerizable groups. For example, a free radically polymerizable component can be prepared by reacting DESMODUR® N100 aliphatic polyisocyanate resin based on hexamethylene diisocyanate (Bayer Corp., Milford, Conn.) with hydroxyethyl acrylate and pentaerythritol triacrylate. Useful free radically polymerizable compounds include NK Ester A-DPH (dipentaerythritol hexaacrylate) that is available from Kowa American, and Sartomer 399 (dipentaerythritol pentaacrylate), Sartomer 355 (di-trimethylolpropane tetraacrylate), Sartomer 295 (pentaerythritol tetraacrylate), and Sartomer 415 [ethoxylated (20)trimethylolpropane triacrylate] that are available from Sartomer Company, Inc.

Numerous other free radically polymerizable components are known in the art and are described in considerable literature including Photoreactive Polymers: The Science and Technology of Resists, A Reiser, Wiley, New York, 1989, pp. 102-177, by B.M. Monroe in Radiation Curing: Science and Technology, S.P. Pappas, Ed., Plenum, New York, 1992, pp. 399-440, and in "Polymer Imaging" by A.B. Cohen and P. Walker, in Imaging Processes and Material, J.M. Sturge et al. (Eds.), Van Nostrand Reinhold, New York, 1989, pp. 226-262, For example, useful free radically polymerizable components are also described in EP 1,182,033A1 (Fujimaki et al.), beginning with paragraph [0170], and in U.S Patents 6,309,792 (Hauck et al.), 6,569,603 (Furukawa), and 6,893,797 (Munnelly et al.).

Other useful free radically polymerizable components include those described in U.S. Patent Application Publication 2009/0142695 (Baumann et al.), which radically polymerizable components include 1H-tetrazole groups.

The one or more free radically polymerizable components are generally present in a radiation-sensitive imageable layer in an amount of at least 10 weight % and up to and including 70 weight %, or typically of at least 20 weight % and up to and including 50 weight %, all based on the total dry weight of the radiation-sensitive imageable layer.

In addition, the radiation-sensitive imageable layer comprises one or more radiation absorbers to provide desired radiation sensitivity or to convert radiation to heat, or both. In some embodiments, the one or more radiation absorbers are one or more different infrared radiation absorbers located in an infrared radiation-sensitive imageable layer so that the lithographic printing plate precursors can be imaged with infrared radiation-emitting lasers.

Useful infrared radiation absorbers can be pigments or infrared radiation absorbing dyes. Suitable dyes also those described in for example, U.S. Patents 5,208,135 (Patel et al.), 6,153,356 (Urano et al.), 6,309,792 (Hauck et al.), 6,569,603 (Furukawa), 6,797,449 (Nakamura et al.), 7,018,775 (Tao), 7,368,215 (Munnelly et al.), 8,632,941 (Balbinot et al.), and U.S. Patent Application Publication 2007/056457 (Iwai et al.).

In some infrared radiation-sensitive embodiments, it is desirable that at least one infrared radiation absorber in the infrared radiation-sensitive imageable layer is a cyanine dye comprising a suitable cationic cyanine chromophore and a tetraarylborate anion such as a tetraphenylborate anion. Examples of such dyes include those described in United States Patent Application Publication 2011/003123 (Simpson et al.).

In addition to low molecular weight IR-absorbing dyes, IR dye chromophores bonded to polymers can be used as well. Moreover, IR dye cations can be used as well, that is, the cation is the IR absorbing portion of the dye salt that ionically interacts with a polymer comprising carboxy, sulfo, phospho, or phosphono groups in the side chains.

The total amount of one or more radiation absorbers is at least 0.5 weight % and up to and including 30 weight %, or typically of at least 1 weight % and up to and including 15 weight %, based on the total dry weight of the radiation-sensitive imageable layer.

The color-forming composition described above is present in the radiation-sensitive imageable layer, and the components (a) through (d) can be present in the following amounts, all based on the total dry weight of the radiation-sensitive imageable layer (which amounts generally correspond to the relative % solids amounts described above for the color-forming composition):

The one or more (a) acid generators can be present in an amount of at least 1 weight % and up to and including 15 weight %, or at least 3 weight % and up to and including 10 weight %.

The one or more (b) tetraaryl borates can be present in an amount of at least 1 weight % and up to and including 15 weight %, or at least 3 weight % and up to and including 10 weight %.

When component (a) and component (b) are present in the same molecule, the combined molecule can be present in an amount of at least 1 weight % and up to and including 15 weight %, or more likely at least 3 weight % and up to and including 10 weight %.

The one or more (c) acid-sensitive dye precursors are present in an amount of at least 0.5 weight % and up to and including 10 weight %, or at least 2 weight % and up to and including 8 weight %.

The one or more (d) compounds defined by Structure (I) are present in an amount of at least 0.5 weight % and up to and including 10 weight %, or at least 2 weight % and up to and including 8 weight %.

Any one of the essential components described above, including one or more free radically polymerizable components, one or more infrared radiation absorbers, and components (a) through (d) in the color forming composition can be polymeric.

It is optional but desirable in some embodiments that the radiation-sensitive imageable layer further comprise a "non-functional" polymeric material that does not have any functional groups that, if present, would make the polymeric material fit the descriptions for other essential components in the imageable layer such as the polymerizable compounds, the infrared radiation absorber and components (a) through (d) in the color forming composition.

Such non-functional polymeric materials can be selected from polymeric binder materials known in the art including polymers comprising recurring units having side chains comprising polyalkylene oxide segments such as those described in for example, U.S. Patent 6,899,994 (Huang et al.).

Other useful non-functional polymeric binders comprise two or more types of recurring units having different side chains comprising polyalkylene oxide segments as described in for example WO Publication 2015-156065 (Kamiya et al.). Some of such polymeric binders can further comprise recurring units having pendant cyano groups as those

described in for example U.S. Patent 7,261,998 (Hayashi et al.).

Some useful polymeric binders, including non-functional polymeric binders and binders having functional groups as described for other essential components in the imageable layer, can be present in particulate form, that is, in the form of discrete particles (non-agglomerated particles). Such discrete particles can have an average particle size of at least 10 nm and up to and including 1500 nm, or typically of at least 80 nm and up to and including 600 nm, and that are generally distributed uniformly within the radiation-sensitive imageable layer. Some polymeric binders can be present as particles having an average particle size of at least 50 nm and up to and including 400 nm. Average particle size can be determined by various known methods including measuring the particles in electron scanning microscope images and averaging a set number of measurements.

In some embodiments, the polymeric binder is present in the form of particles having an average particle size that is less than the average dry thickness (t) of the radiation-sensitive imageable layer. The average dry thickness (t) in micrometers (μm) is calculated by the following Equation:

$$t = w/r$$

wherein w is the dry coating coverage of the radiation-sensitive imageable layer in $g/m^2$ and r is 1 $g/cm^3$. For example, in such embodiments, the polymeric binder can comprise at least 0.05% and up to and including 80%, or more likely at least 10% and up to and including 50%, of the average dry thickness (t) of the radiation-sensitive imageable layer.

The polymeric binders also can have a backbone comprising multiple (at least two) urethane moieties as well as pendant groups comprising the polyalkylenes oxide segments.

Useful polymeric binders generally have a weight average molecular weight (Mw) of at least 2,000 and up to and including 500,000, or at least 20,000 and up to and including 300,000, as determined by Gel Permeation Chromatography (polystyrene standard).

Useful polymeric binders can be obtained from various commercial sources or they can be prepared using known procedures and starting materials, as described for example in publications described above.

The total polymeric binders can be present in the radiation-sensitive imageable layer in an amount of at least 10 weight % and up to and including 70 weight %, or more likely in an amount of at least 20 weight % and up to and including 50 weight %, based on the total dry weight of the radiation-sensitive imageable layer.

The radiation-sensitive imageable layer can include crosslinked polymer particles having an average particle size of at least 2 μm, or of at least 4 μm, and up to and including 20 μm as described for example in U.S. Serial No. 14/642,876 (filed March 10, 2015 by Hayakawa et al.) and in U.S. Patents 8,383,319 (Huang et al.) and 8,105,751 (Endo et al).

Such crosslinked polymeric particles can be present only in the radiation-sensitive imageable layer, the protective layer when present (described below), or in both the radiation-sensitive imageable layer and the protective layer when present.

The radiation-sensitive imageable layer can also include a variety of other optional addenda including but not limited to, dispersing agents, humectants, biocides, plasticizers, surfactants for coatability or other properties, viscosity builders, pH adjusters, drying agents, defoamers, preservatives, antioxidants, development aids, rheology modifiers, or combinations thereof, or any other addenda commonly used in the lithographic art, in conventional amounts. The radiation-sensitive imageable layer can also include a phosphate (meth)acrylate having a molecular weight generally greater than 250 as described in U.S. Patent 7,429,445 (Munnelly et al.).

Hydrophilic Protective Layer:

While in some embodiments of the present invention, the radiation-sensitive imageable layer is the outermost layer with no layers disposed thereon, it is possible that the precursors according to this invention can be designed with a hydrophilic protective layer (also known in the art as a hydrophilic overcoat, oxygen-barrier layer, or topcoat) disposed directly on the radiation-sensitive imageable layer (no intermediate layers between these two layers).

When present, this hydrophilic protective layer is generally the outermost layer of the precursor and thus, when multiple precursors are stacked one on top of the other, the hydrophilic protective layer of one precursor can be in contact with the backside of the substrate of the precursor immediately above it, where no interleaving paper is present.

Such hydrophilic protective layers can comprise one or more film-forming water-soluble polymeric binders in an amount of at least 60 weight % and up to and including 100 weight %, based on the total dry weight of the hydrophilic protective layer. Such film-forming water-soluble (or hydrophilic) polymeric binders can include a modified or unmodified poly(vinyl alcohol) having a saponification degree of at least 30%, or a degree of at least 75%, or a degree of at least 90%, and a degree of up to and including 99.9%.

Further, one or more acid-modified poly(vinyl alcohol)s can be used as film-forming water-soluble (or hydrophilic)

polymeric binders in the hydrophilic protective layer. For example, at least one modified poly(vinyl alcohol) can be modified with an acid group selected from the group consisting of carboxylic acid, sulfonic acid, sulfuric acid ester, phosphonic acid, and phosphoric acid ester groups. Examples of such materials include but are not limited to, sulfonic acid-modified poly(vinyl alcohol), carboxylic acid-modified poly(vinyl alcohol), and quaternary ammonium salt-modified poly(vinyl alcohol), glycol-modified poly(vinyl alcohol), or combinations thereof.

The optional hydrophilic overcoat can also include crosslinked polymer particles having an average particle size of at least 2 $\mu$m and as described for example in U.S. Patents 9,366,962 (Hayakawa et al.), 8,383,319 (Huang et al.) and 8,105,751 (Endo et al).

When present, the hydrophilic protective layer is provided as a hydrophilic protective layer formation and dried to provide a dry coating coverage of at least 0.1 g/m$^2$ and up to but less than 4 g/m$^2$, and typically at a dry coating coverage of at least 0.15 g/m$^2$ and up to and including 2.5 g/m$^2$. In some embodiments, the dry coating coverage is as low as 0.1 g/m$^2$ and up to and including 1.5 g/m$^2$ or at least 0.1 g/m$^2$ and up to and including 0.9 g/m$^2$, such that the hydrophilic protective layer is relatively thin for easy removal during off-press development or on-press development.

The hydrophilic protective layer can optionally comprise organic wax particles dispersed, generally uniformly, within the one or more film-forming water-soluble (or hydrophilic) polymeric binders as described for example in U.S. Patent Application Publication 2013/0323643 (Balbinot et al.).

The radiation-sensitive lithographic printing plate precursors according to the present invention can be provided in the following manner. A radiation-sensitive imageable layer formulation comprising materials described above can be applied to a hydrophilic surface of a suitable substrate, usually as a continuous substrate web, as described above using any suitable equipment and procedure, such as spin coating, knife coating, gravure coating, die coating, slot coating, bar coating, wire rod coating, roller coating, or extrusion hopper coating. Such formulation can also be applied by spraying onto a suitable substrate. Typically, once the radiation-sensitive imageable layer formulation is applied at a suitable wet coverage, it is dried in a suitable manner known in the art to provide a desired dry coverage as noted below, thereby providing a radiation-sensitive continuous web or a radiation-sensitive continuous article.

As noted above, before the radiation-sensitive imageable layer formulation is applied, the substrate (that is, a continuous roll or web) has been electrochemically grained and anodized as described above to provide a suitable hydrophilic anodic oxide layer on the outer surface of the aluminum-containing support, and the anodized surface usually can be post-treated with a hydrophilic polymer solution as described above. The conditions and results of these operations are well known in the art as described above in the Substrate section.

The manufacturing methods typically includes mixing the various components needed for the radiation-sensitive imageable layer in a suitable organic solvent or mixtures thereof with or without water [such as methyl ethyl ketone (2-butanone), methanol, ethanol, 1-methoxy-2-propanol, 2-methoxypropanol, iso-propyl alcohol, acetone, $\gamma$-butyrolactone, n-propanol, tetrahydrofuran, and others readily known in the art, as well as mixtures thereof], applying the resulting radiation-sensitive imageable layer formulation to a continuous substrate web, and removing the solvent(s) by evaporation under suitable drying conditions. After proper drying, the dry coating coverage of the radiation-sensitive imageable layer on the substrate is generally at least 0.1 g/m$^2$ and up to and including 4 g/m$^2$ or at least 0.4 g/m$^2$ and up to and including 2 g/m$^2$ but other dry coverage amounts can be used if desired.

In some embodiments, the radiation-sensitive imageable layer formulation used in this method is an infrared radiation-sensitive imageable layer formulation in which the one or more radiation absorbers are one or more infrared radiation absorbers.

As described above, in some embodiments, a suitable aqueous-based hydrophilic protective layer formulation (described above) can be applied to the dried radiation-sensitive imageable layer using known coating and drying conditions, equipment, and procedures.

In practical manufacturing conditions, the result of these coating operations is a continuous radiation-sensitive web (or roll) of radiation-sensitive lithographic printing plate precursor material having either only a radiation-sensitive imageable layer or both a radiation-sensitive imageable layer and a protective layer disposed on substrate such as a continuous substrate web.

## Imaging (Exposing) Conditions

During use, a radiation-sensitive lithographic printing plate precursor of this invention can be exposed to a suitable source of exposing radiation depending upon the radiation absorber present in the radiation-sensitive imageable layer. In some embodiments where the radiation-sensitive imageable layer contains infrared radiation absorbers, the corresponding lithographic printing plate precursors can be imaged with infrared lasers that emit significant infrared radiation within the range of at least 750 nm and up to and including 1400 nm, or of at least 800 nm and up to and including 1250 nm.

Imaging can be carried out using imaging or exposing radiation from a radiation-generating laser (or array of such lasers). Imaging also can be carried out using imaging radiation at multiple wavelengths at the same time if desired.

The laser used to expose the precursor is usually a diode laser, because of the reliability and low maintenance of diode laser systems, but other lasers such as gas or solid-state lasers can also be used. The combination of power, intensity and exposure time for radiation imaging would be readily apparent to one skilled in the art.

The imaging apparatus can be configured as a flatbed recorder or as a drum recorder, with the radiation-sensitive lithographic printing plate precursor mounted to the interior or exterior cylindrical surface of the drum. An example of useful imaging apparatus is available as models of KODAK® Trendsetter platesetters (Eastman Kodak Company) and NEC AMZISetter X-series (NEC Corporation, Japan) that contain laser diodes that emit radiation at a wavelength of about 830 nm. Other suitable imaging apparatus includes the Screen PlateRite 4300 series or 8600 series platesetters (available from Screen USA, Chicago, IL) or thermal CTP platesetters from Panasonic Corporation (Japan) that operates at a wavelength of 810 nm.

In embodiments where an infrared radiation source is used, imaging energies can be at least 30 mJ/cm$^2$ and up to and including 500 mJ/cm$^2$ and typically at least 50 mJ/cm$^2$ and up to and including 300 mJ/cm$^2$ depending upon the sensitivity of the radiation-sensitive imageable layer.

**Processing (Development) and Printing**

After imagewise exposing, the exposed radiation-sensitive lithographic printing plate precursors having exposed regions and non-exposed regions in the radiation-sensitive imageable layer are processed on-press to remove the non-exposed regions (and any hydrophilic protective layer over such regions). During lithographic printing, the revealed hydrophilic substrate surface repels inks while the remaining exposed regions accept lithographic printing ink.

The lithographic printing plate precursors according to the present invention are on-press developable. In such embodiments, an imaged radiation-sensitive lithographic printing plate precursor according to the present invention can be mounted onto a printing press and the printing operation is begun. The non-exposed regions in the radiation-sensitive imageable layer are removed by a suitable fountain solution, lithographic printing ink, or a combination of both, when the initial printed impressions are made. Typical ingredients of aqueous fountain solutions include pH buffers, desensitizing agents, surfactants and wetting agents, humectants, low boiling solvents, biocides, antifoaming agents, and sequestering agents. A representative example of a fountain solution is Varn Litho Etch 142W + Varn PAR (alcohol sub) (available from Varn International, Addison, IL).

In a typical printing press startup with a sheet-fed printing machine, the dampening roller is engaged first and supplies fountain solution to the mounted imaged precursor to swell the exposed radiation-sensitive imageable layer at least in the non-exposed regions. After a few revolutions, the inking rollers are engaged, and they supply lithographic printing ink(s) to cover the entire printing surface of the lithographic printing plates. Typically, within 5 to 20 revolutions after the inking roller engagement, printing sheets are supplied to remove the non-exposed regions of the radiation-sensitive imageable layer from the lithographic printing plate as well as materials on a blanket cylinder if present, using the resulting lithographic printing ink-fountain solution emulsion.

On-press developability of the lithographic printing precursors is particularly useful when the precursor comprises one or more polymeric binders in the radiation-sensitive imageable layer, at least one of which polymeric binders is present as particles having an average diameter of at least 50 nm and up to and including 400 nm.

The following Examples are provided to illustrate the practice of this invention and are not meant to be limiting in any manner. Unless otherwise indicated, the materials used in the working examples were obtained from various commercial sources as shown after TABLE 1.

**Inventive Example 1 and Comparative Examples 1-3:**

Lithographic printing plate precursors for Inventive Example 1 and for Comparative Examples 1-3 were prepared by applying to an aluminum support (electrochemically roughened in hydrochloric acid, anodized in phosphoric acid and further treated with polyacrylic acid), the following radiation-sensitive imageable layer formulations containing a color-forming composition. The materials shown in TABLE I (in parts) were dissolved or dispersed at a total solid content of 5 weight % in a solvent mixture containing 32 weight % of n-propanol, 10 weight % of 2-methoxy propanol, 40 weight % of 2-butanone, and 18 weight % of water. The radiation-sensitive imageable layer formulations were applied using a wire-wound coating bar and dried at 80°C for 2 minutes to provide a radiation-sensitive imageable layer having a dry coverage of 1 g/m$^2$.

It is to be noted that the precursor of Inventive Example 1 was prepared according to the present invention and the radiation-sensitive imageable layer comprised components (a) through (d) as described above.

The precursors of Comparative Examples 1-3 had radiation-sensitive imageable layers that did not contain a (d) compound represented by Structure (I). The precursor of Comparative Example 4 had a radiation-sensitive imageable layer that contained a (d) compound represented by Structure (I) but did not contain a (b) tetraaryl borate.

TABLE I

| | Comparative Example 1 | Inventive Example 1 | Comparative Example 2 | Comparative Example 3 | Comparative Example 4 |
|---|---|---|---|---|---|
| Polymer 1 | 35.50 | 33.50 | 33.50 | 33.50 | 33.50 |
| UN-904 | 40.00 | 40.00 | 40.00 | 40.00 | 40.00 |
| Klucel E | 5.00 | 5.00 | 5.00 | 5.00 | 5.00 |
| Initiator 1 | 9.00 | 9.00 | 9.00 | 9.00 | |
| Initiator 2 | | | | | 9.00 |
| IR Dye 1 | 4.00 | 4.00 | 4.00 | 4.00 | 4.00 |
| Leuco Dye 1 | 5.00 | 5.00 | 5.00 | 5.00 | 5.00 |
| BYK® 302 | 1.50 | 1.50 | 1.50 | 1.50 | 1.50 |
| 4-Chlorocatechol ($\sigma$ = +0.227) | | 2.00 | | | 2.00 |
| 4-Chlororesorcinol | | | 2.00 | | |
| Chlorohydroquinone | | | | 2.00 | |
| Total | 100.00 | 100.00 | 100.00 | 100.00 | 100.00 |

Materials shown in TABLE 1 are identified as follows:
Polymer 1 is a copolymer derived from acrylonitrile, styrene, and polyethylene glycol methyl ether methacrylate (MW 2000) applied from a polymer dispersion and prepared like Polymer A in U.S. Patent 7,592,128 (Huang et al.).

UN-904 is a polyfunctional urethane acrylate available from Negami Chemical Corporation (Japan).

Polymer 2 is a hydroxypropyl cellulose having a weight average molecular weight around 80,000 Daltons.

Initiator 1 is bis(t-butylphenyl) iodonium tetraphenyl borate.

Initiator 2 is bis(t-butylphenyl) iodonium hexafluorophosphate

IR Dye 1 is an infrared absorbing cyanine dye having the following chemical structure:

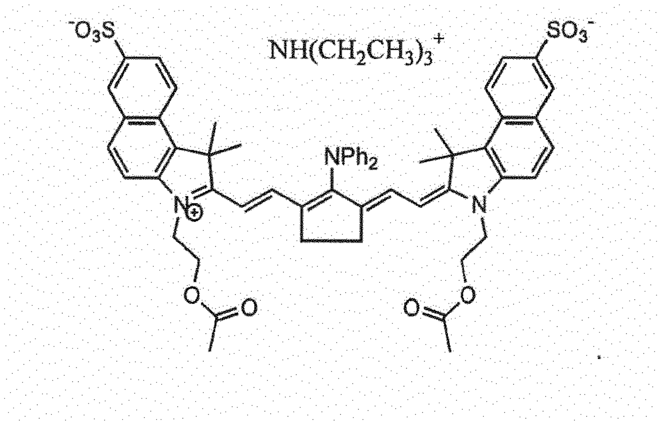

Leuco Dye 1:

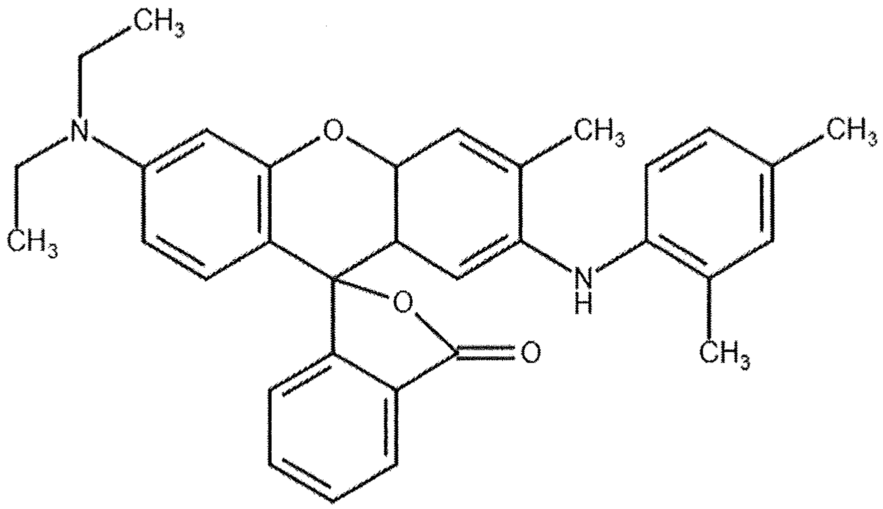

BYK® 302 is a silicone surfactant available from BYK Chemie GmbH (Germany).

4-Chlorocatechol, 4-chlororesorcinol, and chlorohydroquinone were obtained from a commercial source of chemicals.

Each of the prepared negative-working lithographic printing plate precursors were then imaged on a Magnus 800 III platesetter (available from Eastman Kodak Company) at 120 mJ/cm$^2$. After imaging, the difference in optical density between exposed and unexposed regions (ΔOD) on these imaged printing plate precursors were periodically measured for up to 24 hours using an X-rite 528 densitometer (neutral filter). Each of the ΔOD values was then normalized by the ΔOD value of a fresh imaged precursor of Comparative Example 1, used as control, to evaluate the printout images. The ΔOD value serves as an indicator for visibility of the printout images on the imaged printing plate precursors with a higher ΔOD being better. The results of these tests are shown in FIG. 1 and in TABLE II below.

As it can be seen from FIG.1, the lithographic printing plate precursor of Inventive Example 1 exhibited higher initial ΔOD than those of Comparative Examples 1-3. After imaging, the ΔOD values faded for all the lithographic printing plate precursors, but the ΔOD value for the precursor of Inventive Example 1 remained higher than that of Comparative Examples 1-3. In Comparative Example 1, 4-chlorocatechol [(d) compound of Structure (1)] of Inventive Example 1 was omitted, and the resulting precursor exhibited the lowest ΔOD values. In Comparative Examples 2 and 3, 4-chlorocatechol was replaced with its isomers 4-chlororesorcinol and chlorohydroquinone, respectively. These precursors exhibited slightly higher initial ΔOD values than that of Comparative Example 1, but after 24 hours, the difference in ΔOD values among these comparative examples had essentially vanished.

Comparative Examples 2 and 3 demonstrate that it is essential that the two hydroxy groups had to be at *ortho* positions in Structure (I) relative to each other in order to achieve the benefit of high printout image visibility.

It can be seen from the data presented in FIG. 2 that the presence of a (b) tetraarylborate and a (d) compound represented by Structure (I) is essential both for fresh printout and printout stability. The (b) tetraarylborate was not present in Comparative Example 4.

The printout values of freshly imaged precursors and the printout values after 24 hours of storage are shown in the following TABLE II.

TABLE II: Fresh and faded printout values for Inventive Example 1 and Comparative Examples 1-4

| | **(d) Compound of Structure (I)** | **(b) Tetraaryl borate** | **ΔOD immediately after imaging** | **ΔOD after 24 hours dark storage of imaged precursor** |
|---|---|---|---|---|
| Comparative Example 1 | No | Yes | 1.00 | 0.61 |
| Invention Example 1 | Yes | Yes | 1.30 | 0.85 |
| Comparative Example 2 | No | Yes | 1.07 | 0.63 |
| Comparative Example 3 | No | Yes | 1.11 | 0.64 |

(continued)

| | (d) Compound of Structure (I) | (b) Tetraaryl borate | ΔOD immediately after imaging | ΔOD after 24 hours dark storage of imaged precursor |
|---|---|---|---|---|
| Comparative Example 4 | Yes | No | 0.87 | 0.62 |

**Inventive Examples 2-4 and Comparative Examples 5-7:**

Inventive Example 1 was repeated with 4-chlorocatechol in the radiation-sensitive imageable layer being replaced with the compounds shown in the following TABLE III.

TABLE III: Fresh and Faded Printout Values

| Example | (d) Compound of Structure (I) | Sum of Hammett-sigma Values for "R" substituents | d/b Molar Ratio | ΔOD immediately after imaging | ΔOD after 24 hours dark storage of imaged precursor |
|---|---|---|---|---|---|
| Inventive 1 | 4-Chlorocatechol | +0.227 | 1.10 | 1.30 | 0.85 |
| Inventive 2 | 4-Nitrocatechol | +0.778 | 1.02 | 1.32 | 0.96 |
| Inventive 3 | Ethyl 3,4-dihydroxy benzoate (EDB) | +0.450 | 0.87 | 1.36 | 0.88 |
| Inventive 4 | Propyl gallate | +0.08 | 0.75 | 1.35 | 0.93 |
| Comparative 5 | Pyrogallol | -0.37 | 1.26 | 1.25 | 0.79 |
| Comparative 6 | 4-*t*-Butylcatechol | -0.197 | 0.95 | 1.18 | 0.73 |
| Comparative 7 | 3-Methoxycatechol | -0.269 | 1.13 | 1.01 | 0.63 |

It can be seen from the results shown in TABLE III that imaged precursors containing compounds represented by Structure (I) according to the present invention provided stronger fresh printout images (higher ΔOD) and printout images after 24 hours of dark storage compared to the precursor of Comparative Example 1 where no such compounds were added to the radiation-sensitive imageable layer. The High fresh and faded ΔOD values in Inventive Examples 2-4 relative to the values for Comparative Examples 5-7 show the benefits of using compounds represented by Structure (I) wherein at least one of the R groups is an electron withdrawing group.

**Inventive Example 5:**

Inventive Example 3 was repeated for eleven precursor samples except that the amount of ethyl 3,4-dihydroxybenzoate (EDB) was varied as shown in the following TABLE IV while adjusting the amount of Polymer 1 to balance each of the formulations in this precursor series.

| Precursor Sample | Weight % EDB | d/b ratio | ΔOD immediately after imaging | ΔOD after 24 hours dark storage of imaged precursor |
|---|---|---|---|---|
| 5-1 | 0.00 | 0 | 1.00 | 0.57 |
| 5-2 | 1.00 | 0.43:1 | 1.39 | 0.82 |
| 5-3 | 1.50 | 0.65:1 | 1.46 | 0.96 |
| 5-4 | 2.00 | 0.87:1 | 1.47 | 1.01 |
| 5-5 | 2.50 | 1.09:1 | 1.47 | 1.01 |
| 5-6 | 3.00 | 1.30:1 | 1.49 | 1.04 |

(continued)

| Precursor Sample | Weight % EDB | d/b ratio | ΔOD immediately after imaging | ΔOD after 24 hours dark storage of imaged precursor |
|---|---|---|---|---|
| 5-7 | 3.50 | 1.52:1 | 1.50 | 1.06 |
| 5-8 | 4.00 | 1.74:1 | 1.50 | 1.07 |
| 5-9 | 5.00 | 2.17:1 | 1.54 | 1.10 |
| 5-10 | 6.00 | 2.61:1 | 1.54 | 1.11 |
| 5-11 | 7.00 | 3.04:1 | 1.53 | 1.10 |

The ΔOD printout values relative to fresh control without Component (d), both immediately after imaging and after 24 hours dark storage of the imaged precursor, were plotted as a function of the molar ratio of Component (d) to Component (b) (the d/b ratio) as shown in FIG. 3.

As it can be seen from Fig. 3, the incremental benefits from increasing the amount of Component (d) leveled off with the d/b ratio at about 0.5:1 for fresh ΔOD printout and at about 0.75:1 for the ΔOD printout values after 24 hours dark storage.

## Claims

1. A color-forming composition comprising:

   (a) an acid generator;
   (b) a tetraaryl borate;
   (c) an acid-sensitive dye precursor; and
   (d) a compound having the following Structure (1):

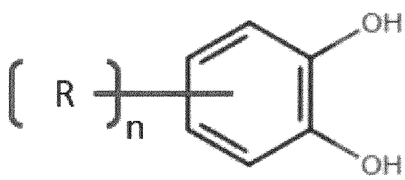

(I)

   wherein n is 1, 2, 3, or 4; R independently represents a monovalent substituent or the atoms necessary to form a fused ring if n is at least 2, and at least one R substituent is an electron-withdrawing group.

2. The color-forming composition of claim 1, wherein the sum of *para* Hammett-Sigma values for the at least one R substituent is greater than 0.

3. The color-forming composition of claim 1 or 2, wherein the (a) acid generator is an onium salt.

4. The color-forming composition of any of claims 1 to 3, wherein the (a) acid generator and the (b) tetraaryl borate are present in the color-forming composition as one molecule comprising an acid-generating cation and a tetraaryl borate anion.

5. The color-forming composition of any of claims 1 to 4, wherein the (a) acid generator is an onium salt having an iodonium cation.

6. The color-forming composition of any of claims 1 to 5, wherein the (d) compound of Structure (I) is selected from

the group consisting of an alkyl 3,4-dihydroxybenzoate, an alkyl gallate, 4-chlorocatechol, 4-nitrocatechol, and 3,4-dihydroxybenzonitrile.

**7.** The color-forming composition of any of claims 1 to 6, wherein the molar ratio of the (d) compound of Structure (I) to the (b) tetraaryl borate is at least 0.25:1 and up to and including 3:1.

**8.** A lithographic printing plate precursor comprising:

a substrate comprising a hydrophilic surface;
a radiation-sensitive imageable layer that is disposed on the hydrophilic surface of the substrate, the radiation-sensitive imageable layer comprising:

one or more free radically polymerizable components,
one or more radiation absorbers,
a color-forming composition of any of claims 1 to 7, and
optionally, a polymeric material different from the one or more free radically polymerizable components, and

the lithographic printing plate precursor optionally comprising a protective layer disposed over the radiation-sensitive imageable layer.

**9.** The lithographic printing plate precursor of claim 8 that is on-press developable using a lithographic printing ink, a fountain solution, or a combination of a lithographic printing ink and a fountain solution.

**10.** The lithographic printing plate precursor of claim 8 or 9, wherein the radiation-sensitive imageable layer comprises two or more free radically polymerizable components.

**11.** The lithographic printing plate precursor of any of claims 8 to 10, wherein the radiation-sensitive imageable layer comprises one or more polymeric binders, at least one of which polymeric binders is present as particles having an average particle size of at least 50 nm and up to and including 400 nm.

**12.** The lithographic printing plate precursor of any of claims 8 to 11, wherein the radiation-sensitive imageable layer is an infrared radiation-sensitive imageable layer, and the one or more radiation absorbers are one or more infrared radiation absorbers.

**13.** A method for forming a lithographic printing plate, comprising:

A) imagewise exposing a lithographic printing plate precursor according to any of claims 8 to 12 with radiation, to provide exposed regions and non-exposed regions in the radiation-sensitive imageable layer; and
B) removing the non-exposed regions of the radiation-sensitive imageable layer.

**14.** The method of claim 13, comprising
B) removing the non-exposed regions of the radiation-sensitive imageable layer on-press using a lithographic printing ink, a fountain solution, or a combination of a lithographic printing ink and a fountain solution.

**15.** The method of claim 13 or 14, wherein the radiation-sensitive imageable layer comprises an infrared radiation absorber, and the imagewise exposing is carried out using infrared radiation.

## Patentansprüche

**1.** Eine farbbildende Zusammensetzung, umfassend:

(a) einen Säurebildner;
(b) ein Tetraarylborat;
(c) einen säureempfindlichen Farbstoffvorläufer; und
(d) eine Verbindung mit der folgenden Struktur (I):

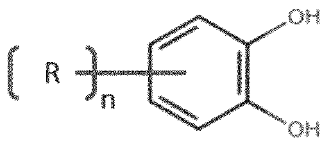

(I)

wobei n gleich 1, 2, 3 oder 4 ist; R unabhängig einen einwertigen Substituenten oder die zur Bildung eines kondensierten Rings erforderlichen Atome, wenn n mindestens 2 ist, darstellt, und mindestens ein Substituent R ein elektronenziehender Rest ist.

**2.** Die farbbildende Zusammensetzung nach Anspruch 1, wobei die Summe an para-Hammett-Sigma-Werten für den mindestens einen Substituenten R größer als 0 ist.

**3.** Die farbbildende Zusammensetzung nach Anspruch 1 oder 2, wobei der (a) Säurebildner ein Oniumsalz ist.

**4.** Die farbbildende Zusammensetzung nach einem der Ansprüche 1 bis 3, wobei der (a) Säurebildner und das (b) Tetraarylborat in der farbbildenden Zusammensetzung als ein Molekül vorliegen, das ein säurebildendes Kation und ein Tetraarylborat-Anion umfasst.

**5.** Die farbbildende Zusammensetzung nach einem der Ansprüche 1 bis 4, wobei der (a) Säurebildner ein Oniumsalz mit einem Iodonium-Kation ist.

**6.** Die farbbildende Zusammensetzung nach einem der Ansprüche 1 bis 5, wobei die (d) Verbindung der Struktur (I) ausgewählt ist aus der Gruppe bestehend aus einem Alkyl-3,4-dihydroxybenzoat, einem Alkylgallat, 4-Chlorcatechin, 4-Nitrocatechin und 3,4-Dihydroxybenzonitril.

**7.** Die farbbildende Zusammensetzung nach einem der Ansprüche 1 bis 6, wobei das Molverhältnis der (d) Verbindung der Struktur (I) zu dem (b) Tetraarylborat mindestens 0,25:1 und bis zu und einschließlich 3:1 beträgt.

**8.** Ein Lithographie-Druckplattenvorläufer, umfassend:

einen Träger, umfassend eine hydrophile Oberfläche;
eine strahlungsempfindliche bebilderbare Schicht, die auf der hydrophilen Oberfläche des Trägers angeordnet ist, wobei die strahlungsempfindliche bebilderbare Schicht umfasst:

eine oder mehrere radikalisch polymerisierbare Komponenten,
einen oder mehrere Strahlungsabsorber,
eine farbbildende Zusammensetzung nach einem der Ansprüche 1 bis 7 und gegebenenfalls ein von der einen oder den mehreren radikalisch polymerisierbaren Komponenten verschiedenes polymeres Material, und

wobei der Lithographie-Druckplattenvorläufer gegebenenfalls eine Schutzschicht umfasst, die über der strahlungsempfindlichen bebilderbaren Schicht angeordnet ist.

**9.** Der Lithographie-Druckplattenvorläufer nach Anspruch 8, welcher unter Verwendung einer Lithographie-Druckfarbe, eines Feuchtmittels oder einer Kombination aus einer Lithographie-Druckfarbe und eines Feuchtmittels auf der Presse entwickelbar ist.

**10.** Der Lithographie-Druckplattenvorläufer nach Anspruch 8 oder 9, wobei die strahlungsempfindliche bebilderbare Schicht zwei oder mehr radikalisch polymerisierbare Komponenten umfasst.

**11.** Der Lithographie-Druckplattenvorläufer nach einem der Ansprüche 8 bis 10, wobei die strahlungsempfindliche bebilderbare Schicht ein oder mehrere polymere Bindemittel umfasst, wobei mindestens eines der polymeren Bindemittel als Teilchen mit einer mittleren Teilchengröße von mindestens 50 nm und bis zu und einschließlich 400 nm

vorliegt.

**12.** Der Lithographie-Druckplattenvorläufer nach einem der Ansprüche 8 bis 11, wobei die strahlungsempfindliche bebilderbare Schicht eine für Infrarot-Strahlung empfindliche bebilderbare Schicht ist und der eine oder die mehreren Strahlungsabsorber ein oder mehrere Infrarotstrahlungsabsorber sind.

**13.** Ein Verfahren zur Bildung einer Lithographie-Druckplatte, umfassend:

A) bildweises Belichten eines Lithographie-Druckplattenvorläufers nach einem der Ansprüche 8 bis 12 mit Strahlung, um belichtete Bereiche und nicht-belichtete Bereiche in der strahlungsempfindlichen bebilderbaren Schicht bereitzustellen; und
B) Entfernen der nicht-belichteten Bereiche der strahlungsempfindlichen bebilderbaren Schicht.

**14.** Das Verfahren nach Anspruch 13, umfassend
B) Entfernen der nicht-belichteten Bereiche der strahlungsempfindlichen bebilderbaren Schicht auf der Presse unter Verwendung einer Lithographie-Druckfarbe, eines Feuchtmittels oder einer Kombination aus einer Lithographie-Druckfarbe und einem Feuchtmittel.

**15.** Das Verfahren nach Anspruch 13 oder 14, wobei die strahlungsempfindliche bebilderbare Schicht einen Infrarotstrahlungsabsorber umfasst und die bildweise Belichtung unter Verwendung von Infrarotstrahlung durchgeführt wird.

**Revendications**

**1.** Composition de formation de couleur comprenant :

(a) un générateur d'acide ;
(b) un borate de tétraaryle ;
(c) un précurseur de colorant sensible aux acides ; et
(d) un composé ayant la structure (I) suivante :

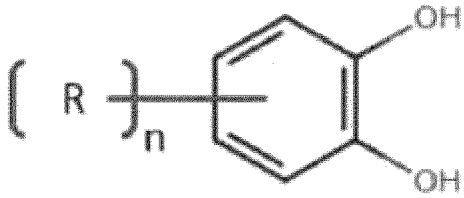

(I)

dans laquelle n est 1, 2, 3, ou 4 ; R représente indépendamment un substituant monovalent ou les atomes nécessaires pour former un cycle condensé si n est au moins 2, et au moins un substituant R est un groupe attracteur d'électrons.

**2.** Composition de formation de couleur selon la revendication 1, dans laquelle la somme des valeurs de Sigma de Hammett en *para* pour l'au moins un substituant R est supérieure à 0.

**3.** Composition de formation de couleur selon la revendication 1 ou 2, dans laquelle le générateur d'acide (a) est un sel d'onium.

**4.** Composition de formation de couleur selon l'une quelconque des revendications 1 à 3, dans laquelle le générateur d'acide (a) et le borate de tétraaryle (b) sont présents dans la composition de formation de couleur sous la forme d'une molécule comprenant un cation générateur d'acide et un anion de borate de tétraaryle.

**5.** Composition de formation de couleur selon l'une quelconque des revendications 1 à 4, dans laquelle le générateur

d'acide (a) est un sel d'onium ayant un cation iodonium.

6. Composition de formation de couleur selon l'une quelconque des revendications 1 à 5, dans laquelle le composé (d) de structure (I) est sélectionné dans le groupe consistant en un 3,4-dihydroxybenzoate d'alkyle, un gallate d'alkyle, le 4-chlorocatéchol, le 4-nitrocatéchol, et le 3,4-dihydroxybenzonitrile.

7. Composition de formation de couleur selon l'une quelconque des revendications 1 à 6, dans laquelle le rapport molaire du composé (d) de structure (I) par rapport au borate de tétraaryle (b) est d'au moins 0,25:1 et jusqu'à 3:1 compris.

8. Précurseur de plaque d'impression lithographique comprenant :

un substrat comprenant une surface hydrophile ;
une couche imageable sensible aux rayonnements qui est disposée sur la surface hydrophile du substrat, la couche imageable sensible aux rayonnements comprenant :

un ou plusieurs composants polymérisables par voie radicalaire,
un ou plusieurs absorbeurs de rayonnements, une composition de formation de couleur selon l'une quelconque des revendications 1 à 7, et
facultativement, un matériau polymère différent des un ou plusieurs composants polymérisables par voie radicalaire, et

le précurseur de plaque d'impression lithographique comprenant facultativement une couche protectrice disposée sur la couche imageable sensible aux rayonnements.

9. Précurseur de plaque d'impression lithographique selon la revendication 8, qui peut être développé sur presse en utilisant une encre d'impression lithographique, une solution de mouillage, ou une combinaison d'une encre d'impression lithographique et d'une solution de mouillage.

10. Précurseur de plaque d'impression lithographique selon la revendication 8 ou 9, dans lequel la couche imageable sensible aux rayonnements comprend deux composants polymérisables par voie radicalaire ou plus.

11. Précurseur de plaque d'impression lithographique selon l'une quelconque des revendications 8 à 10, dans lequel la couche imageable sensible aux rayonnements comprend un ou plusieurs liants polymères, au moins l'un des liants polymères étant présent sous forme de particules ayant une taille particulaire moyenne d'au moins 50 nm et jusqu'à 400 nm compris.

12. Précurseur de plaque d'impression lithographique selon l'une quelconque des revendications 8 à 11, dans lequel la couche imageable sensible aux rayonnements est une couche imageable sensible aux rayonnements infrarouges, et les un ou plusieurs absorbeurs de rayonnements sont un ou plusieurs absorbeurs de rayonnements infrarouges.

13. Méthode de formation d'une plaque d'impression lithographique, comprenant :

A) l'exposition à une image d'un précurseur de plaque d'impression lithographique selon l'une quelconque des revendications 8 à 12 avec un rayonnement, pour fournir des régions exposées et des régions non exposées dans la couche imageable sensible aux rayonnements ; et
B) le retrait des régions non exposées de la couche imageable sensible aux rayonnements.

14. Méthode selon la revendication 13, comprenant
B) le retrait des régions non exposées de la couche imageable sensible aux rayonnements sur presse en utilisant une encre d'impression lithographique, une solution de mouillage, ou une combinaison d'une encre d'impression lithographique et d'une solution de mouillage.

15. Méthode selon la revendication 13 ou 14, dans laquelle la couche imageable sensible aux rayonnements comprend un absorbeur de rayonnements infrarouges, et l'exposition à une image est réalisée en utilisant un rayonnement infrarouge.

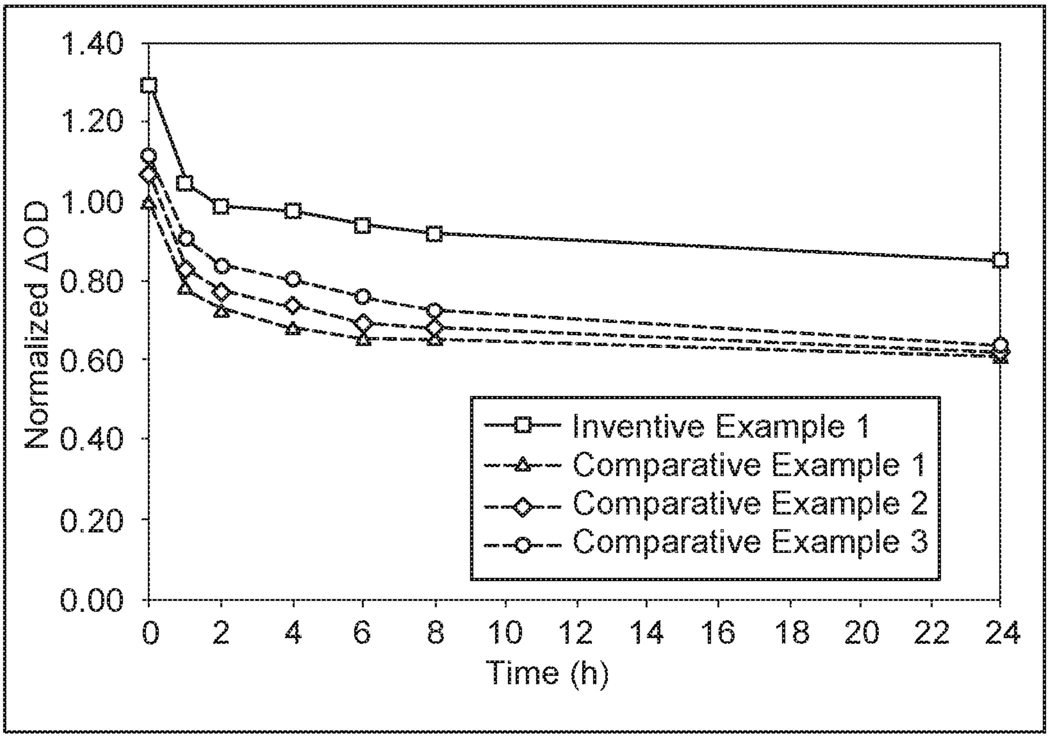
1.40
1.20
1.00
0.80
0.60
0.40
0.20
0.00
Normalized ΔOD
0
2
4
6
8
10
12
14
16
18
20
22
24
Time (h)
Inventive Example 1
Comparative Example 1
Comparative Example 2
Comparative Example 3

*FIG. 1*

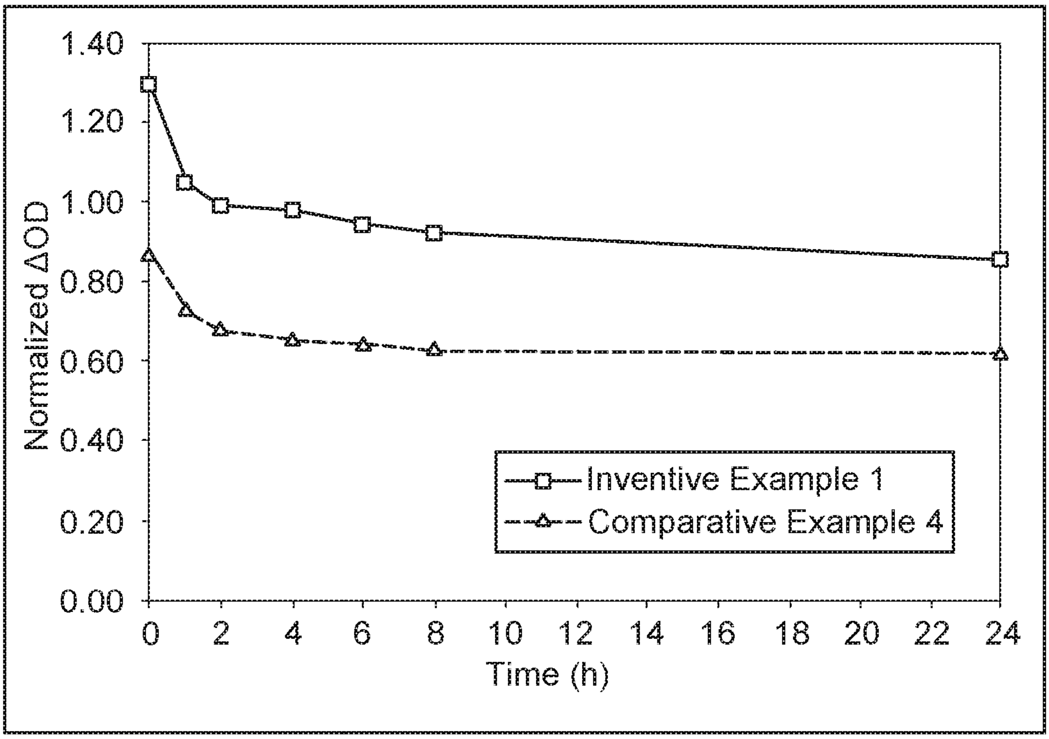
1.40
1.20
1.00
0.80
0.60
0.40
0.20
0.00
Normalized ΔOD
0
2
4
6
8
10
12
14
16
18
20
22
24
Time (h)
Inventive Example 1
Comparative Example 4

*FIG. 2*

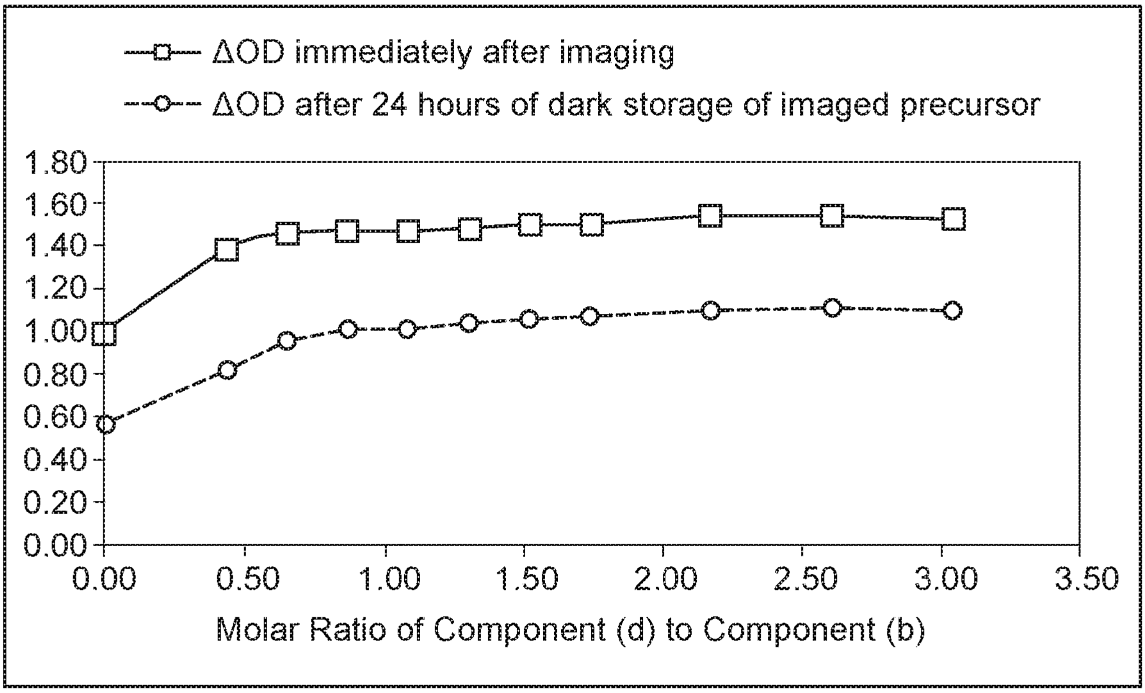
ΔOD immediately after imaging
ΔOD after 24 hours of dark storage of imaged precursor
1.80
1.60
1.40
1.20
1.00
0.80
0.60
0.40
0.20
0.00
0.00
0.50
1.00
1.50
2.00
2.50
3.00
3.50
Molar Ratio of Component (d) to Component (b)

*FIG. 3*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20090047599, Horne
- US 20050170282, Inno
- US 7524614 B, Tao
- JP 2002082429 A
- US 20020051934, Ippei
- US 20130052582 A, Hayashi
- US 447651 A, Merka
- EP 1182033 A1, Fujimaki
- US 6309792 B, Hauck
- US 6569603 B, Furukawa
- US 6893797 B, Munnelly
- US 20090142695, Baumann
- US 5208135 A, Patel
- US 6153356 A, Urano
- US 6309792 A, Hauck
- US 6569603 A, Furukawa
- US 6797449 A, Nakamura
- US 7018775 A, Tao
- US 7368215 A, Munnelly
- US 8632941 A, Balbinot
- US 2007056457, Iwai
- US 2011003123, Simpson
- US 6899994 B, Huang
- WO 2015156065 A, Kamiya
- US 7261998 B, Hayashi
- US 64287615, Hayakawa
- US 8383319 B, Huang
- US 8105751 B, Endo
- US 7429445 B, Munnelly
- US 9366962 B, Hayakawa
- US 20130323643, Balbinot
- US 7592128 B, Huang


### Non-patent literature cited in the description


- Glossary of Basic Terms in Polymer Science. Pure Appl. Chem. International Union of Pure and Applied Chemistry, 1996, vol. 68, 2287-2311
- **A REISER.** Photoreactive Polymers: The Science and Technology of Resists. Wiley, 1989, 102-177
- **B.M. MONROE.** Radiation Curing: Science and Technology. Plenum, 1992, 399-440
- Polymer Imaging. **A.B. COHEN ; P. WALKER et al.** Imaging Processes and Material. Van Nostrand Reinhold, 1989, 226-262